# EUROPEAN PATENT SPECIFICATION

(11) **EP 2 547 181 B1**
(45) Date of publication and mention of the grant of the patent: **29.03.2017**
(21) Application number: 11173581.7
(22) Date of filing: 12.07.2011
(51) Int. Cl.: H05K 1/02, H05K 9/00, H03K 17/0812, H03K 17/0814

(54) **A protection device for ESD protection**
Schutzvorrichtung zum Schutz vor elektrostatischer Entladung
Dispositif de protection pour protection ESD

(43) Date of publication of application: 16.01.2013
(73) Proprietor: Delphi Technologies, Inc., Troy, MI 48007 (US)
(72) Inventor: Wendel, Werner, 31275 Lehrte (DE)
(74) Representative: Manitz, Finsterwald & Partner GbR

(56) References cited:
- TW-A- 201 041 454
- US-A1- 2006 066 417
- US-A1- 2009 021 873
- US-A1- 2010 277 840

## Description

### Technical Field

The present invention relates to a protection device for protecting semiconductor devices or other electronic components and circuits against electrostatic discharge (ESD).

### Background of the Invention

Electronic integrated circuits, components, and other semiconductor devices generally operate at a voltage of 5 volts or less, and are therefore susceptible to damage by ESD. In particular, types of field effect transistors (FETs), especially those used for RF applications, can be damaged or destroyed by static voltages as low as 100 volts. RF components and circuits are susceptible to damage because of thin semiconductor layers, and the input stages of circuits which are capable of amplifying very small signals are especially sensitive to ESD. Known solutions to this problem include the integration of additional electronic devices (such as diodes) into a circuit for the sole purpose of protecting against ESD. These devices ground any voltage above a predetermined level in order to protect the circuit. A disadvantage of using these devices is their influence (due to capacitor effects) on the operation of the circuit itself. Another known solution is the use an LC network connected to the circuit input, and which acts as a filter to remove a portion of the pulse generated by ESD. A disadvantage of such LC networks is the negative effect these networks have on frequency response, which for certain circuits is unacceptable. In other words, the known protection devices can have a negative impact on the noise, frequency response and/or gain of the circuits these devices are meant to be protecting. Several applications deal with ESD related solutions.

US2006066417A1 discloses a way, how to achieve equal wiring lengths and a uniform characteristic impedance in high differential transmission systems, even when ESD protection elements are attached to the signal paths The Patent US 2009/0021873 A1 shows a compact design for an ESD protection based on diodes, which can be integrated together with the device to be protected. Additional advantage is a low capacitance. Taiwanese patent 201041454 describes an RF electrostatic discharge protection circuit. Another document, the US 2010/0277840 A1, uses a meander inductor in its ESD design to avoid stray effects in higher frequency ranges.

### Summary of the Invention

The aim of the present invention is to provide a protection device for connection to an electronic component or circuit to protect such component or circuit against ESD, and which does not exhibit the negative effects of previously known devices.

A protection device in accordance with the present invention is defined by the features specified in claim 1.

The present invention also includes an integrated circuit comprising an electronic circuit with a protection device in accordance with the present invention connected thereto.

The present invention overcomes the problems associated with the prior art in that the sharp corners of the conductive line cause a portion of the hazardous signal (ESD pulse) to be reflected back towards its source (for example, the antenna which may be the point of entrance for the ESD pulse/hazardous signal). The conductive line, along with the first and second circuit means, act as a filter to mitigate the effects of ESD, without having any substantive effect on the operation of the electronic circuit to which the protection device is connected.

### Brief Description of the Drawings

The present invention will now be described, by way of example, with reference to the accompanying drawings, in which:-
Figure 1 is a circuit diagram of a protection device in accordance with the present invention; Figure 1 is a circuit diagram of a protection device in accordance with the present invention;
Figure 2 is a perspective view of the conductive line and substrate of the protection device of Figure 1;
Figure 3 is an enlarged view of one of the sharp corners of the conductive line of Figure 1.
Figure 4 is a graph illustrating insertion loss versus frequency when the protection circuit of Figure 1 is used; and
Figure 5 is a graph similar to Figure 4 illustrating insertion loss versus frequency when the protection circuit of Figure 1 is not used.

### Description of the Preferred Embodiment

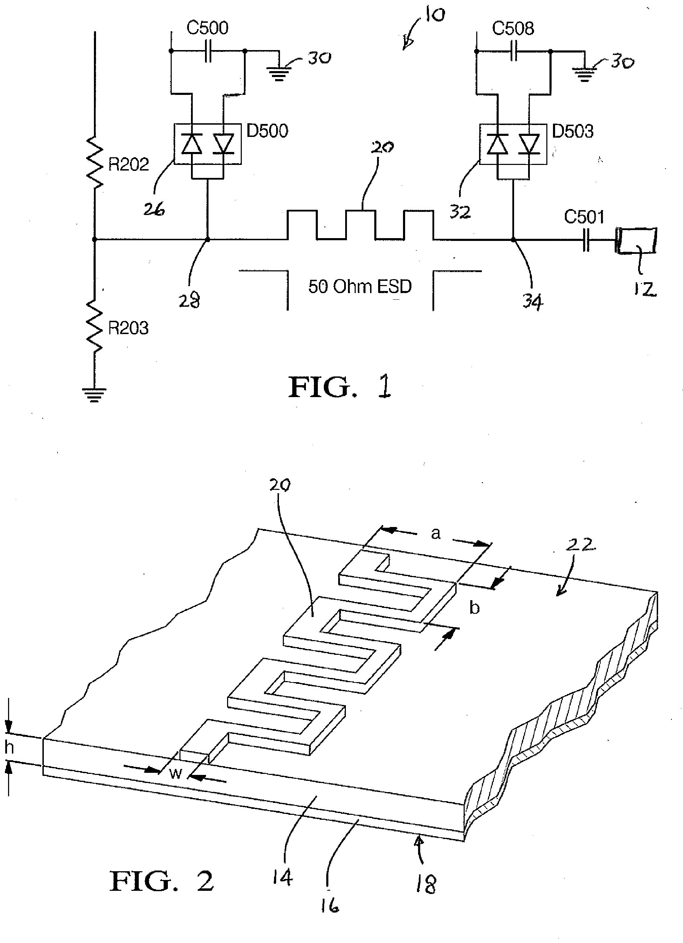

Referring to Figure 1-3, a protection device 10, in accordance with the present invention, for protecting an electronic component or circuit 12 (such as an amplifier circuit connected to an antenna) against electrostatic discharge, comprises a substrate 14 formed from dielectric material; an electrically conductive ground plane 16 formed on one side 18 of the substrate; an electrically conductive line 20 formed on the other side 22 of the substrate, the conductive line having a non-linear profile and including one or more sharp corners 24; a first circuit means 26 electrically connected to one end 28 of the conductive line which is capable of diverting at least a portion of electrostatic discharge to electrical ground 30; and a second circuit means 32 electrically connected to the other end 34 of the conductive line which is capable of diverting at least a portion of electrostatic discharge to electrical ground. Figure 1 also includes a capacitor C501 (which protects the input from DC signals), and resistors R202 and R203, which are not part of the protection circuit but are shown for reasons of completeness of an RF input circuitry.

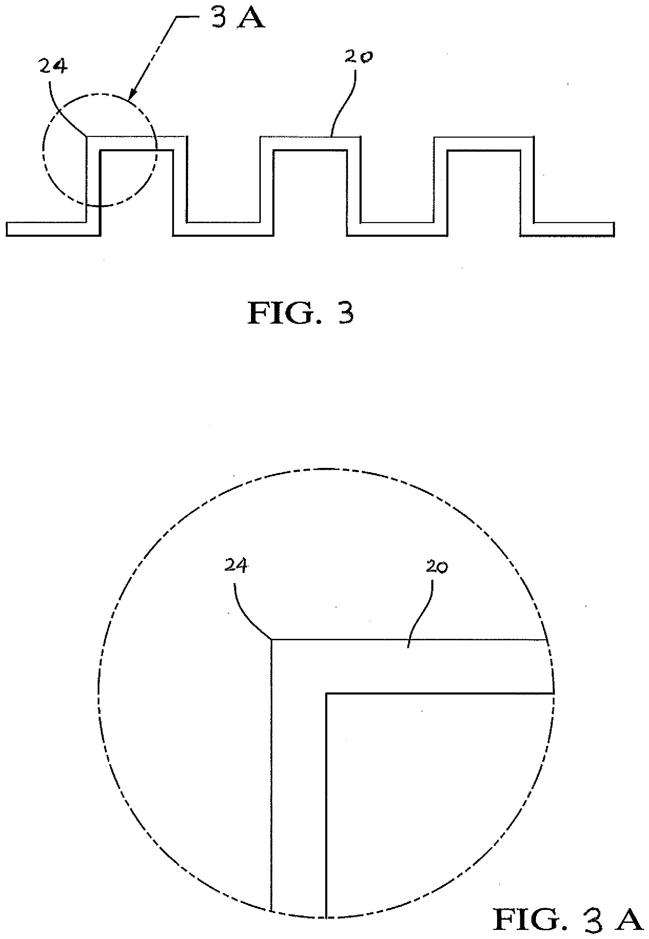

For the sake of clarity in the present invention, the meaning of a non-linear profile is that the conductive line 20 is not a straight line. Also, the meaning of a sharp corner 24 is that the conductive line 20 turns abruptly through a predetermined angle (as shown in Figure 3). In this respect, the conductive line 20 preferably has a castellated profile (comprising one or more square waves) as shown in Figures 1-3. As an alternative, the conductive line 20 may have a zigzag profile (comprising one or more V- or W- shaped profiles). Further alternative profiles may be usable, as long as such profiles include at least one sharp corner.

The conductive line 20 is a conducting metal strip, separated from the conducting ground plane 16, by a dielectric layer (the substrate 14). The substrate 14 may be any suitable material such as ceramic, FR4 (glass fibre reinforced epoxy resin, or PTFE, or may be a printed circuit board. One of the advantages of such a conductive line 20 is that it is easy to produce, has good reproducibility, and is cost effective. The specific profile of the conductive line 20 is important in the present invention. The sharp corners 24 serve as inhomogeneity for the electromagnetic waves. The ground plane 16 acts as a waveguide and the ground plane is separated from the conductive line 20 by the substrate 14.

Figure 2 includes dimensions a and b which represent geometric lengths of the straight parts of the conductive line 20 (a is not necessarily equal to b); h is the height of the substrate 14; w is the width of the conductive line 20; and εᵣ is the permittivity of the substrate 14. These dimensions/values are variables which are determined by simulation software to get an optimized result for a specific frequency range.

In the preferred embodiment shown in Figures 1-3, the first and second circuit means 26, 32 each comprise a pair of diodes connected in parallel to one another which act to serve to shorten overvoltage (divert to ground) on the conductive line 20. A possible alternative to diodes may be a "spark gap" which would be construed as apexes which are very close together (etched in the copper surface of the PCB). Only one spark gap would be necessary since the polarity would play no role. The high electric field strength would cause a spark which would also divert the voltage to ground. Further alternative arrangements include the use of other semiconductor devices.

Any electrostatic discharge creates a pulse which, because of its shortness, can be seen as a travelling wave, propagating from its point of entry (any point on the conductive line 20) to the input of the circuit 12. The pulse hits the non-linear conductive line 20, and the line acts as a form of RF (radiofrequency) network. The sharp corners 24 of the conductive line 20 cause a portion of the ESD pulse to be reflected back on itself. Additionally, the pulse consists, mathematically, of a plurality of sinusoidal oscillations (such as Fourier). Any frequency component which is outside the bandwidth of the network is blocked. Therefore a portion of the potentially harmful ESD pulse is blocked. Further still, the diodes of the first circuit means 26 become conductive and neutralize another part of the ESD pulse. Further still, the diodes of the second circuit means 32 shorten another part of the pulse in the same manner. When the diodes become conductive, there is a mismatch between conductive line 20 and the input to the circuit 12 which causes any remaining part of the ESD pulse is be reflected back. As the diodes have a recovery time, the ESD pulse effectively sees a short circuit at the diode which reflects the pulse back in the other direction when the travelling time of the pulse is shorter than the recovery time of the diode. Finally, the pulse is damped to zero as reflection is repeated.

The configuration (shape and size) of the conductive line 20 is determined to match the input impedance of the circuit 12 in any frequency range used by the circuit 12. Unlike prior art arrangements using discrete elements (resistors, capacitors, inductances), the conductive line 20 can be designed to have minimal affect on frequency response. The capacitance of the diodes does not influence the signal as the diodes can also be taken into consideration when determining the required configuration for the conductive line 20. Another advantage of the use of a conductive line 20 is that the line can be specifically designed for a broader frequency range, which is difficult to achieve when using single components. Test results shows that the protection device of the present invention can work effectively to 25 kV without influencing the behaviour of the protected circuit 12.

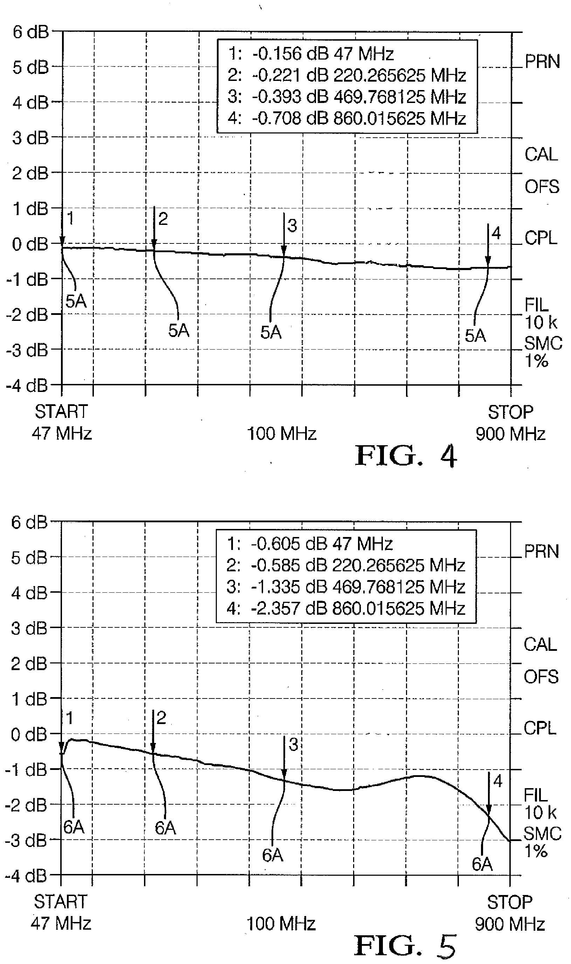

Figure 5 shows the measurement of a scattering parameter s21 (s-parameters) with a conventional LC network but without a protective device in accordance with the present invention. The improvement provided by the present invention can be seen in Figure 4. Both figures have the same sample marks 1-4 (5a, 6a). The higher the frequency, the bigger is the difference in insertion loss. Figure 4 shows the advantage of the present invention.

The protection device of the present invention may be incorporated into an integrated circuit to protect the electronic circuit of the integrated circuit. The protection device may be connected to the input terminal of the electronic circuit, or to the output terminal of the electronic circuit, or a protection device may be connected to both the input and the output terminal. In this arrangement, a single substrate may be used for both the protection device(s) and the electronic circuit.

The present invention is particularly useful when used in a conjunction with an amplifier circuit connected to an antenna.

## Claims

1. An integrated circuit comprising an electronic component or circuit (12) having an input terminal and an output terminal and a protection device (10) for protecting the electronic component or circuit (12) against electrostatic discharge, the protection device comprising
a substrate (14) formed from dielectric material;
an electrically conductive ground plane (16) formed on one side (18) of the substrate;
an electrically conductive line (20) formed on the other side (22) of the substrate, the conductive line having a non-linear profile and including one or more sharp corners (24);
a first circuit means (26) electrically directly connected to one end (28) of the conductive line which is capable of diverting at least a portion of electrostatic discharge to electrical ground (30); and
a second circuit means (32) electrically directly connected to the other end (34) of the conductive line which is capable of diverting at least a portion of electrostatic discharge to electrical ground (30),
wherein one of the ends of the conductive line (20) is directly connected to the input terminal through a capacitor (C501).

2. An integrated circuit as claimed in claim 1, wherein the first and second circuit means (26, 32) are substantially identical.

3. An integrated circuit as claimed in claim 1 or claim 2, wherein the first and second circuit means (26, 32) each comprise first and second diodes electrically connected in parallel between the conductive line (20) and electrical ground (30).

4. An integrated circuit as claimed in any one of claims 1 to 3, wherein the conductive line (20) has a castellated profile.

5. An integrated circuit as claimed in any one of claims 1 to 3, wherein the conductive line (20) has a zigzag profile.

## Patentansprüche

1. Integrierte Schaltung, die eine elektronische Komponente oder Schaltung (12) mit einem Eingangsanschluss und einem Ausgangsanschluss und eine Schutzvorrichtung (10) zum Schützen der elektronischen Komponente oder Schaltung (12) vor einer elektrostatischen Entladung umfasst, wobei die Schutzvorrichtung umfasst:
ein Substrat (14), das aus einem dielektrischen Material ausgebildet ist;
eine elektrisch leitfähige Masseebene (16), die an einer Seite (18) des Substrats ausgebildet ist;
eine elektrisch leitfähige Leitung (20), die an der anderen Seite (22) des Substrats ausgebildet ist, wobei die leitfähige Leitung ein nichtlineares Profil aufweist und eine oder mehrere scharfe Ecken (24) enthält;
ein erstes mit einem Ende (28) der leitfähigen Leitung elektrisch direkt verbundenes Schaltungsmittel (26), welches in der Lage ist, zumindest einen Teil einer elektrostatischen Entladung an eine elektrische Masse (30) umzuleiten; und
ein zweites mit dem anderen Ende (34) der leitfähigen Leitung elektrisch direkt verbundenes Schaltungsmittel (32), welches in der Lage ist, zumindest einen Teil einer elektrostatischen Entladung an die elektrische Masse (30) umzuleiten,
wobei eines der Enden der leitfähigen Leitung (20) durch einen Kondensator (C501) direkt mit dem Eingangsanschluss verbunden ist.

2. Integrierte Schaltung nach Anspruch 1,
wobei das erste und zweite Schaltungsmittel (26, 32) im Wesentlichen identisch sind.

3. Integrierte Schaltung nach Anspruch 1 oder 2,
wobei das erste und zweite Schaltungsmittel (26, 32) jeweils erste und zweite Dioden umfassen, die zwischen der leitfähigen Leitung (20) und der elektrischen Masse (30) elektrisch parallel verbunden sind.

4. Integrierte Schaltung nach einem der Ansprüche 1 bis 3,
wobei die leitfähige Leitung (20) ein zinnenförmiges Profil aufweist.

5. Integrierte Schaltung nach einem der Ansprüche 1 bis 3,
wobei die leitfähige Leitung (20) ein Zickzackprofil aufweist.

## Revendications

1. Circuit intégré comprenant un composant ou un circuit électronique (12) ayant une borne d'entrée et une borne de sortie et un dispositif de protection (10) pour protéger le composant ou le circuit électronique (12) à l'encontre d'une décharge électrostatique, le dispositif de protection comprenant
un substrat (14) formé d'un matériau diélectrique ;
un plan de masse électriquement conducteur (16) formé sur un côté (18) du substrat ;
une ligne électriquement conductrice (20) formée sur l'autre côté (22) du substrat, la ligne conductrice ayant un profil non linéaire et incluant un ou plusieurs coins vifs (24) ;
un premier moyen formant circuit (26) connecté électriquement directement à une extrémité (28) de la ligne conductrice qui est capable de dériver au moins une portion de décharge électrostatique vers la masse électrique (30) ; et
un second moyen formant circuit (32) connecté électriquement directement à l'autre extrémité (34) de la ligne conductrice qui est capable de dériver au moins une portion de décharge électrostatique vers la masse électrique (30),
dans lequel l'une des extrémités de la ligne conductrice (20) est connectée directement à la borne d'entrée via une capacité (C501).

2. Circuit intégré selon la revendication 1, dans lequel le premier et le second moyen formant circuit (26, 32) sont sensiblement identiques.

3. Circuit intégré selon la revendication 1 ou 2, dans lequel le premier et le second moyen formant circuit (26, 32) comprennent chacun une première et une seconde diode connectées électriquement en parallèle entre la ligne conductrice (20) et la masse électrique (30).

4. Circuit intégré selon l'une quelconque des revendications 1 à 3, dans lequel la ligne conductrice (20) a un profil crénelé.

5. Circuit intégré selon l'une quelconque des revendications 1 à 3, dans lequel la ligne conductrice (20) a un profil en zigzag.
